# EUROPÄISCHE PATENTSCHRIFT

(11) **EP 2 649 870 B1**
(45) Veröffentlichungstag und Bekanntmachung des Hinweises auf die Patenterteilung: **07.01.2015**
(21) Anmeldenummer: 11779391.9
(22) Anmeldetag: 03.11.2011
(51) Int. Cl.: H05K 7/14, H05K 5/00

(54) **ELEKTRISCHE SCHALTUNGSANORDNUNG SOWIE VERFAHREN ZUR HERSTELLUNG EINER ELEKTRISCHEN SCHALTUNGSANORDNUNG**
ELECTRICAL CIRCUIT ARRANGEMENT AND METHOD FOR PRODUCING AN ELECTRICAL CIRCUIT ARRANGEMENT
CIRCUIT ÉLECTRIQUE ET PROCÉDÉ POUR PRODUIRE UN CIRCUIT ÉLECTRIQUE

(30) Priorität: 08.12.2010 DE 102010062586
(43) Veröffentlichungstag der Anmeldung: 16.10.2013
(73) Patentinhaber: Robert Bosch GmbH, 70442 Stuttgart (DE)
(72) Erfinder: STREICHER, Uwe, 71640 Ludwigsburg (DE); HARTHERZ, Patrik, 71640 Ludwigsburg (DE); SCHAEFER, Joerg, 71088 Holzgerlingen (DE)
(86) Internationale Anmeldenummer: PCT/EP2011/069282
(87) Internationale Veröffentlichungsnummer: WO 2012/076260

(56) Entgegenhaltungen:
- EP-A2- 0 991 308
- EP-A2- 1 976 357
- DE-A1- 1 515 463
- US-A- 5 414 223
- US-A- 5 847 934

## Beschreibung

### Stand der Technik

Die Erfindung betrifft eine elektrische Schaltungsanordnung, insbesondere für ein Steuergerät eines Kraftfahrzeugs, mit mindestens einer Leiterplatte und einem Gehäuse, wobei das Gehäuse mindestens einen Führungsbereich zur Führung der mindestens einen Leiterplatte aufweist. Die Erfindung betrifft ferner ein Verfahren zur Herstellung einer elektrischen Schaltungsanordnung, insbesondere zur Fixierung mindestens einer Leiterplatte in einem Gehäuse.

Elektrische Schaltungsanordnungen und Verfahren zu deren Herstellung sind aus dem Stand der Technik bekannt. Die elektrischen Schaltungsanordnungen weisen mindestens eine Leiterplatte und ein Gehäuse auf, in welches die Leiterplatte eingebracht ist. Das Gehäuse weist mindestens einen Führungsbereich auf, welcher die Leiterplatte insbesondere bei deren Einbringen in das Gehäuse führt und in welchen die Leiterplatte bei der Herstellung der elektrischen Schaltungsanordnung zumindest bereichsweise eingebracht wird. Um die Leiterplatte in dem Gehäuse zu fixieren, wird das Gehäuse in dem Führungsbereich zumindest bereichsweise auf eine vorzugsweise metallisierte Fläche der Leiterplatte geprägt. Das Gehäuse wird also bereichsweise mechanisch verformt, so dass es gegen die vorzugsweise metallisierte Fläche der Leiterplatte gedrängt wird, wobei es wiederum die dem verformten Bereich abgewandte Seite der Leiterplatte auf ein im Führungsbereich ausgebildetes Widerlager des Gehäuses drängt. Hierdurch soll zum Einen ein thermischer Kontakt zwischen der Leiterplatte und dem Gehäuse geschaffen werden, zum Anderen soll auch ein ohmscher Kontakt zu dem vorzugsweise geerdeten Gehäuse geschaffen werden, wenn die Fläche der Leiterplatte, auf welche das Gehäuse bereichsweise geprägt wird, metallisiert ist.

Es hat sich gezeigt, dass die aus dem Stand der Technik bekannten elektrischen Schaltungsanordnungen nur eine begrenzte Haltekraft der Leiterplatten in den Gehäusen aufweisen. Dies liegt letztlich daran, dass bei dem bekannten Herstellungsverfahren durch das bereichsweise Prägen des Gehäuses auf eine vorzugsweise metallisierte Fläche der Leiterplatte lediglich ein Kraftschluss verwirklicht wird. Weiterhin hat sich gezeigt, dass der durch Prägen des Gehäuses auf eine metallisierte Fläche entstehende ohmsche Kontakt zwischen dem Gehäuse und der Leiterplatte nicht gasdicht ist. Hierdurch kann sich in dem Kontaktbereich eine Oxidschicht ausbilden, wodurch sich der Kontaktwiderstand verändert, insbesondere hochohmig wird. Ein niederohmiger Kontakt über die Lebensdauer der elektrischen Schaltungsanordnung ist so nicht darstellbar. Auch die aufgrund der ungenügenden mechanischen Fixierung begrenzte Haltekraft zwischen dem Gehäuse und der Leiterplatte führt dazu, dass der Kontakt nicht über die Lebensdauer der elektrischen Schaltungsanordnung niederohmig bleibt, weil eine dichte Anlage der Kontaktflächen aneinander aufgrund von Temperaturwechseln und mechanischen Schwingungen nicht gewährleistet ist, insbesondere wenn die elektrische Schaltungsanordnung ein Steuergerät eines Kraftfahrzeugs ist. Mechanische Schwingungen können auch zu einer Reibkorrosion der Kontaktflächen führen, was wiederum eine Hochohmigkeit des Kontakts zur Folge hat. Aus diesen Gründen kann der durch Aufprägen entstandene elektrische Kontakt zwischen Leiterplatte und Gehäuse nicht als Masseanschluss für auf der Leiterplatte vorgesehene elektrische oder elektronische Bauteile verwendet werden.

Aus der EP 0 991308 A2 ist eine Schaltungsanordnung bekannt, bei welcher das Gehäuse mit einem Gehäusezapfen versehen ist, der in eine Aussparung beziehungsweise Vertiefung der Leiterplatte bei der Montage eingeführt wird. Anschließend wird der Gehäusezapfen plastisch verformt, so dass er Anker-artig die Leiterplatte an dem Gehäuse arretiert.

Ferner ist aus der DE 15 15 463 A1 eine Schaltungsanordnung bekannt, bei welcher ein Gehäuse mittels verformbarer Befestigungslaschen an einem Isoliersockel befestigt ist, wobei die Gehäuselaschen in am Boden des Isoliersockels vorgesehene Aussparungen eingebogen werden.

### Offenbarung der Erfindung

Demgegenüber weist die elektrische Schaltungsanordnung mit den in Anspruch 1 genannten Merkmalen den Vorteil auf, dass die Haltekraft zwischen Leiterplatte und Gehäuse deutlich erhöht, insbesondere die laterale Fixierung der mindestens einen Leiterplatte in dem Gehäuse verbessert ist.
Dies wird erfindungsgemäß erreicht, in dem die mindestens eine Leiterplatte mindestens eine Vertiefung aufweist, und dass das Gehäuse in mindestens einem Verformungsbereich des mindestens einen Führungsbereichs derart mechanisch verformt ist, dass der mindestens eine Verformungsbereich zumindest bereichsweise in die mindestens eine Vertiefung eingeformt ist. Da der Verformungsbereich zumindest bereichsweise in die Vertiefung eingeformt ist, wird ein Formschluss realisiert. Dies führt zu einer deutlich verbesserten Haltekraft in lateraler Richtung, also in den Richtungen, die in der Ebene der Leiterplatte senkrecht aufeinander stehen. Auf diese Weise ist die laterale Fixierung der Leiterplatte deutlich verbessert. Die Leiterplatte kann als Leiterplatine ausgebildet sein. Sie ist bevorzugt mit elektrischen oder elektronischen Bauteilen bestückt, um eine funktionsfähige elektrische Schaltungsanordnung zu realisieren. Sie kann vorzugsweise flexibel oder semiflexibel sein. Insbesondere ist es möglich, flexible Leiterplatinen auf der Basis von Polyimid-Folien oder anderen Polymer-Werkstoffen herzustellen.

Eine Weiterbildung der Erfindung sieht vor, dass die mindestens eine Vertiefung als Struktur, beispielsweise Nut, in einer Metallisierung der Leiterplatte ausgebildet ist. Die Leiterplatte weist in diesem Fall einen metallisierten, vorzugsweise metallisch beschichteten Bereich auf, der an seiner Oberfläche strukturiert ist. Die Strukturierung kann beispielsweise eine oder mehrere Nuten, Sacklöcher oder andere Arten von Vertiefungen umfassen. Insbesondere sind auch geometrische Muster wie Reihen oder Gitter von Vertiefungen möglich. Die Vertiefung kann auch als Nut oder Durchkontaktierung, auch Via genannt, in der Leiterplatte ausgebildet sein. Eine Durchkontaktierung ist vorzugsweise als Durchgangsbohrung oder Loch in der Leiterplatte ausgebildet, sie kann aber auch als Sackloch in der Leiterplatte ausgebildet sein.

Weiterhin sieht die Erfindung vor, dass die mindestens eine Leiterplatte zumindest im Bereich der mindestens einen Vertiefung metallisiert ist. Dies ist beispielsweise der Fall, wenn die Vertiefung als Struktur in einer Metallisierung der Leiterplatte vorgesehen ist. Es ist aber auch möglich, die Vertiefung in der Leiterplatte selbst vorzusehen, beispielsweise als Nut oder Durchkontaktierung, und die Leiterplatte dann zumindest im Bereich dieser Vertiefung zu metallisieren. Wenn das Gehäuse zumindest in dem Verformungsbereich elektrisch leitfähig ist, wird durch die bereichsweise Einformung des Verformungsbereichs in die Vertiefung ein ohmscher Kontakt zwischen der Leiterplatte und dem Gehäuse hergestellt. Anstelle einer Metallisierung kann auch eine leitfähige Füllung in der Vertiefung vorgesehen sein. Der ohmsche Kontakt besteht dann zwischen dem in die Vertiefung eingeformten Bereich des Verformungsbereichs und der leitfähigen Füllung. Es ist auch möglich, die Vertiefung sowohl zu metallisieren als auch eine leitfähige Füllung in derselben vorzusehen. Jedenfalls ist der aufgrund des eingeformten Verformungsbereichs entstandene ohmsche Kontakt gasdicht. Die gasdichte Verbindung der Kontaktflächen behindert, vorzugsweise verhindert deren Oxidation, so dass ein dauerhafter ohmscher Kontakt mit niedrigem Kontaktwiderstand über die Lebensdauer der elektrischen Schaltungsanordnung gewährleistet ist. Aufgrund des Formschlusses und der erhöhten lateralen Fixierung wird der Kontaktwiderstand auch nicht durch Umweltbelastungen, also äußere Einflüsse wie Temperaturschwankungen oder mechanische Schwingungen beeinträchtigt. Auch ein Reibkorrision ist zumindest soweit behindert, vorzugsweise verhindert, dass die Niederohmigkeit des Kontakts über die gesamte Lebensdauer der elektrischen Schaltungsanordnung gewährleistet ist. Es ist dann insbesondere möglich, den Kontakt als Masseanschluss für auf der Leiterplatte vorgesehene elektrische oder elektronische Bauteile zu nutzen. Eine Metallisierung der Vertiefung ist aber auch bezüglich der mechanischen Eigenschaften der Verbindung zwischen dem Gehäuse und der Leiterplatte vorteilhaft. Wird das Gehäuse unmittelbar auf das Material der Leiterplatte oder eine darauf aufgebrachte Lackschicht geprägt, führt dies gegebenenfalls zur Zerstörung der Lackschicht beziehungsweise des Materials in dem Berührungsbereich. Dies hat zur Folge, dass ein definierter mechanischer Kontakt zwischen Leiterplatte und Gehäuse nicht gewährleistet werden kann. Demgegenüber führt das Aufprägen beziehungsweise Einformen des Gehäuses auf beziehungsweise in einen metallisierten Bereich der Leiterplatte dazu, dass ein definierter mechanischer Kontakt ohne Zerstörung des entsprechenden Bereichs der Leiterplatte gebildet wird. Die Metallisierung verbessert auch den thermischen Kontakt zwischen Leiterplatte und Gehäuse.

Eine Weiterbildung der Erfindung sieht vor, dass die Metallisierung beziehungsweise der metallisierte Bereich Kupfer aufweist. Auch andere Metalle sind möglich, die die gewünschten thermischen, elektrischen und/oder mechanischen Eigenschaften aufweisen, insbesondere also den gewünschten thermischen, mechanischen und/oder elektrischen Kontakt zwischen Leiterplatte und Gehäuse gewährleisten. Der metallisierte Bereich beziehungsweise die Metallisierung kann vorzugsweise eine Zinn-Oberfläche aufweisen. Auch andere Oberflächen, insbesondere Oberflächenbeschichtungen sind möglich.

Eine Weiterbildung der Erfindung sieht vor, dass mehr als eine Vertiefung an der mindestens einen Leiterplatte vorgesehen ist. Die Fixierung beziehungsweise Haltekraft der Leiterplatte in dem Gehäuse kann dadurch weiter verbessert werden. Vorzugsweise ist in mindestens einem geführten Bereich der Leiterplatte - in einer Einschubrichtung der Leiterplatte in das Gehäuse gesehen - mindestens eine Reihe von Vertiefungen angeordnet. Der Führungsbereich des Gehäuses dient bevorzugt zur Aufnahme und Führung der Leiterplatte, wenn diese in das Gehäuse eingeschoben wird und anschließend zur Befestigung beziehungsweise Fixierung der Leiterplatte in dem Gehäuse. In Einschubrichtung und damit bevorzugt auch in Richtung einer Längserstreckung des Führungsbereichs ist also bevorzugt eine Anzahl von Vertiefungen nebeneinander in einer Reihe angeordnet. Auf diese Weise wird eine besonders stabile Fixierung der Leiterplatte erreicht. Selbstverständlich sind auch andere geometrische Anordnungen mehr als einer Vertiefung an beziehungsweise auf der Leiterplatte denkbar. Beispielsweise ist es möglich, dass - in einer Richtung gesehen, die senkrecht auf der Einschubrichtung der Leiterplatte in das Gehäuse steht - mindestens eine Reihe von Vertiefungen auf der Leiterplatte angeordnet ist. Auch flächige Anordnungen sind möglich: Beispielsweise können die Vertiefungen einer einzelnen Reihe in Längsrichtung des Führungsbereichs, das heißt in Einschubrichtung, nebeneinander angeordnet sein, während mehrere Reihen von Vertiefungen in der auf dieser Richtung senkrecht stehenden Richtung nebeneinander angeordnet sind. Es ergibt sich dann insgesamt eine flächige, vorzugsweise matrix-artige Anordnung von Vertiefungen. Hierdurch kann die Haltekraft beziehungsweise Fixierung der Leiterplatte weiter gesteigert werden.

Eine Weiterbildung der Erfindung sieht vor, dass das Gehäuse einstückig ist. Hierdurch wird eine gute Dichtigkeit des Gehäuses gewährleistet. Das Gehäuse ist außerdem einfach aufgebaut. Insbesondere müssen nicht zunächst mehrere Gehäuseteile, beispielsweise zwei Gehäusehälften, zusammengefügt werden, bevor die mindestens eine Leiterplatte in das Gehäuse eingebracht wird. Das Gehäuse weist vorzugsweise in dem in die mindestens eine Vertiefung eingeformten Bereich des Verformungsbereichs ein elektrisch leitfähiges Material auf. Bevorzugt ist das Gehäuse aus Aluminium heergestellt. Besonders bevorzugt ist das Gehäuse aus fließgepresstem Aluminium hergestellt. Das Gehäuse kann auch Kunststoff aufweisen, vorzugsweise aus Kunststoff hergestellt sein. Dies hat den Vorteil einer Gewichtsreduktion. Es ist außerdem möglich, das Gehäuse in einem Strangpress-, Spritzguss-, Druckguss-, Tiefzieh-, Hydroforming- oder Thixomolding-Vorgang herzustellen. All diese Verfahren gewährleisten eine schnelle und kostengünstige Herstellung des Gehäuses. Unter Hydroforming ist dabei ein Innenhochdruckumformen zu verstehen Thixomolding ist ein Urformverfahren, welches auch als Semi-Solid Metal Casting bezeichnet wird.

Eine Weiterbildung der Erfindung sieht vor, dass das Gehäuse als Einschubgehäuse ausgebildet ist. In diesem Fall wird die Leiterplatte in das Gehäuse eingeschoben und dabei von dem mindestens einen Führungsbereich aufgenommen und geführt.

Die Erfindung betrifft weiterhin ein Verfahren zur Herstellung einer elektrischen Schaltungsanordnung, insbesondere gemäß den vorstehenden Ausführungen, insbesondere ein Verfahren zur Fixierung mindestens einer Leiterplatte in einem Gehäuse. Dabei wird an der mindestens einen Leiterplatte mindestens eine Vertiefung vorgesehen. Vorzugsweise im Anschluss hieran wird die mindestens eine Leiterplatte zumindest bereichsweise in mindestens einen Führungsbereich eines Gehäuses eingebracht. Bevorzugt ist das Gehäuse als Einschubgehäuse ausgebildet, so dass die mindestens eine Leiterplatte in das Gehäuse eingeschoben wird, wobei sie zumindest bereichsweise von dem Führungsbereich aufgenommen und von diesem geführt wird. Es ist gegebenenfalls auch möglich, die mindestens eine Vertiefung an der mindestens einen Leiterplatte vorzusehen, nachdem diese in das Gehäuse eingebracht wurde. Nach dem Einbringen der Leiterplatte in das Gehäuse wird dieses in mindestens einem Verformungsbereich des mindestens einen Führungsbereichs derart mechanisch verformt, dass der Verformungsbereich zumindest bereichsweise in die mindestens eine Vertiefung eingeformt wird. Hierdurch wird ein Formschluss zwischen der Leiterplatte und dem Gehäuse hergestellt. Die mindestens eine Vertiefung kann als Struktur in einer Metallisierung der Leiterplatte oder in der Leiterplatte selbst als Durchkontaktierung, vorzugsweise Durchgangsbohrung, Loch, oder auch als Sackloch vorgesehen werden. Sie kann metallisiert und/oder mit einer leitfähigen Füllung gefüllt werden. Durch die bereichsweise Einformung des Verformungsbereichs in die mindestens eine Vertiefung wird eine Art Niet in die Leiterplatte ausgebildet.

Eine Weiterbildung der Erfindung sieht vor, dass der Verformungsbereich zumindest bereichsweise in die mindestens eine Vertiefung eingeprägt wird. Hierzu ist bevorzugt ein Prägestempel vorgesehen, mit Hilfe dessen mindestens eine Fläche eines vorzugsweise metallisch verformbaren Gehäuses auf mindestens eine vorzugsweise metallisierte Fläche der Leiterplatte geprägt wird. Dies wird auch als Hohlprägung bezeichnet. Beim Prägevorgang wird durch die Umformung ein vorzugsweise elektrisch leitfähiger, insbesondere metallischer Bereich des Gehäuses in die Vertiefung gedrückt. Bevorzugt ist der Prägestempel so groß ausgebildet, dass er - in mindestens einer Richtung gesehen - mehr als eine Vertiefung auf der Leiterplatte erfasst. Es kann dann mit einem Prägestempel in ein und demselben Prägevorgang eine bereichsweise Einformung eines Verformungsbereichs in mehr als eine Vertiefung erfolgen. Das Verfahren wird hierdurch besonders zeitsparend und wirtschaftlich.

Eine Weiterbildung der Erfindung sieht vor, dass im Bereich der Einformung des mindestens einen Verformungsbereichs in die mindestens eine Vertiefung ein ohmscher Kontakt zwischen der mindestens einen Leiterplatte und dem Gehäuse hergestellt wird. Weil der auf diese Weise hergestellte ohmsche Kontakt über die gesamte Lebensdauer der elektrischen Schaltungsanordnung niederohmig bleibt, ist es insbesondere möglich, ihn als Masseanschluss für auf der Leiterplatte vorgesehene elektrische oder elektronische Bauteile zu verwenden.

Die Erfindung wird im Folgenden anhand der in der Zeichnung dargestellten Ausführungsbeispiele näher erläutert, ohne dass eine Beschränkung der Erfindung erfolgt. Dabei zeigen:
- Figur 1: eine beidseitig abgebrochene, schematische Querschnittansicht eines Ausführungsbeispiels einer elektrischen Schaltungsanordnung mit Leiterplatte und Gehäuse vor der mechanischen Verformung, sowie die schematische Darstellung eines Prägestempels, und
- Figur 2: eine beidseitig abgebrochene, schematische Darstellung der elektrischen Schaltungsanordnung sowie des Prägestempels gemäß Figur 1 nach der mechanischen Verformung.

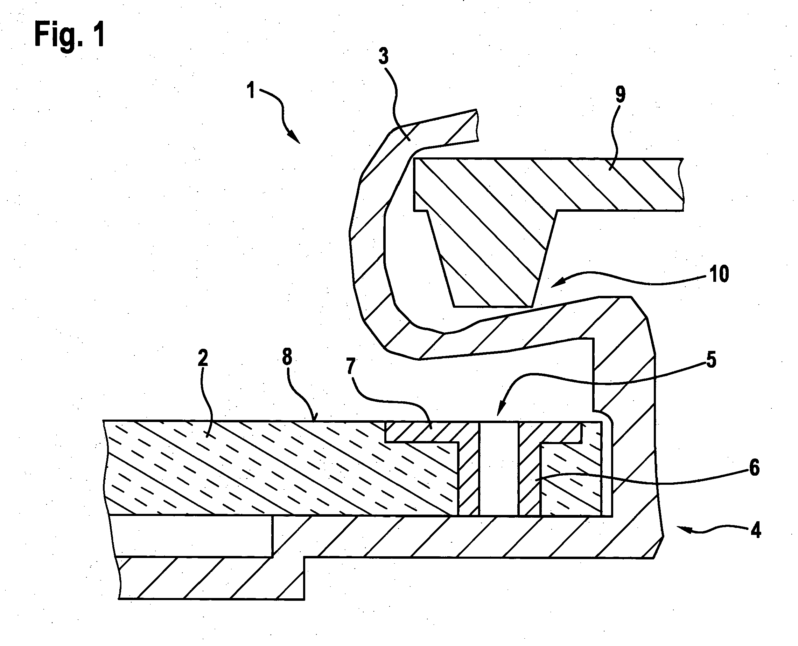

Figur 1 zeigt eine beidseitig abgebrochene, schematische Darstellung eines Ausführungsbeispiels einer elektrischen Schaltungsanordnung 1, die ein Leiterplatte 2 und ein Gehäuse 3 aufweist. Das Gehäuse 3 weist auf der hier dargestellten Seite einen Führungsbereich 4 zur Führung der Leiterplatte 2 auf. Vorzugsweise ist das Gehäuse 3 bezüglich einer senkrecht auf der Bildebene stehenden Ebene spiegelsymmetrisch ausgebildet und weist dementsprechend auf der dem Führungsbereich 4 bezüglich der Spiegelebene gegenüberliegenden Seite ebenfalls einen Führungsbereich auf. Insbesondere ist das Gehäuse 3 bevorzugt als Einschubgehäuse ausgebildet, wobei die Leiterplatte 2 in die Bildebene hinein in das Gehäuse 3 eingeschoben und dabei bereichsweise zumindest von dem Führungsbereich 4, bevorzugt auch von dem gegenüberliegenden Führungsbereich, aufgenommen und geführt wird. Der Führungsbereich 4 weist - in einer Richtung gesehen, die senkrecht auf der Bildebene steht - eine Längserstreckung auf.

Die Leiterplatte 2 weist mindestens eine Vertiefung auf, die hier als Durchkontaktierung 5, insbesondere als Durchgangsbohrung oder Loch ausgebildet ist. Bei dem dargestellten Ausführungsbeispiel ist die Durchkontaktierung 5 mit einer Metallisierung 6, also einem metallisierten Bereich versehen. Die Durchkontaktierung 5 kann bereichsweise oder vollständig metallisiert sein. Die Metallisierung 6 weist vorzugsweise Kupfer, besonders bevorzugt mit einer Zinn-Oberfläche auf. Besonders bevorzugt ist die Durchkontaktierung 5 im Bereich einer metallisierten Fläche, nämlich eines sogenannten Pads 7 vorgesehen. Die metallisierte Fläche oder das Pad 7 bildet einen Bereich einer Oberfläche 8 der Leiterplatte 2. Die Durchkontaktierung 5 weist bevorzugt einen kreisförmigen Querschnitt auf. Es ist aber auch möglich, eine - im Querschnitt gesehen - ovale oder längliche Durchkontaktierung an der Leiterplatte 2 vorzusehen.

In Figur 1 ebenfalls schematisch dargestellt ist ein Prägestempel 9 in einer Ausgangsstellung. Dieser wirkt mit einem Verformungsbereich 10 des Führungsbereichs 4 so zusammen, dass der Verformungsbereich 10 mechanisch verformt wird. Es ist offensichtlich, dass der Prägestempel 9 in seiner Ausgangsstellung noch nicht mit dem Verformungsbereich 10 zusammenwirkt. Bei dem dargestellten Ausführungsbeispiel verlagert sich der Prägestempel 9 zur Verformung des Verformungsbereichs 10 im Wesentlichen in Richtung einer Längsachse der Durchkontaktierung 5. Es ist auch möglich, dass sich der Prägestempel 9 schräg zu der Längsachse der Durchkontaktierung 5 verlagert, um eine Verformung des Verformungsbereichs 10 zu bewirken. Dies wird als gewinkeltes Prägen bezeichnet.

Die Leiterplatte 2 kann mehr als eine Durchkontaktierung 5 aufweisen. Bevorzugt sind in Richtung der Längserstreckung des Führungsbereichs 4 mehr als eine Durchkontaktierung 5 nebeneinander vorgesehen, so dass diese eine Reihe bilden. Ist das Gehäuse 3 als Einschubgehäuse ausgebildet, erstreckt sich die Längserstreckung des Führungsbereichs 4 in Einschubrichtung der Leiterplatte 2 in das Gehäuse. Mit dem Führungsbereich 4 des Gehäuses 3 wirkt mindestens ein geführter Bereich der Leiterplatte 2 zusammen. Die Reihe, welche mehrere Durchkontaktierungen 5 nebeneinander aufweist, erstreckt sich dann in dem geführten Bereich in Einschubrichtung der Leiterplatte 2 in das Gehäuse 3. Auch das Pad 7 erstreckt sich dann bevorzugt in Richtung der Längserstreckung des Führungsbereichs 4 zumindest über einen Bereich, in dem auch die Reihe aus Durchkontaktierungen 5 vorgesehen ist. Bevorzugt sind demnach alle Durchkontaktierungen 5 im Bereich des Pads 7 vorgesehen. Es ist auch möglich, im Bereich jeder Durchkontaktierung 5 ein separates Pad 7 vorzusehen.

Es können auch mehrere Durchkontaktierungen 5, insbesondere mehr als eine Reihe von Durchkontaktierungen 5 in einer Richtung nebeneinander angeordnet sein, die senkrecht auf der Richtung der Längserstreckung des Führungsbereichs 4 steht. Diese Richtung verläuft in der Bildebene von Figur 1 und erstreckt sich dort parallel zur Erstreckung der Leiterplatte 2. Der Prägestempel 9 ist vorzugsweise insbesondere in Richtung der Längserstreckung des Führungsbereichs 4 gesehen, aber gegebenenfalls auch in der hierzu senkrechten Richtung gesehen, so breit, dass er mehr als eine Durchkontaktierung 5 erfasst, wenn er mit dem Verformungsbereich 10 zusammenwirkt.

Die hier im Zusammenhang mit dem Ausführungsbeispiel beschriebenen geometrischen Anordnungen von Durchkontaktierungen 5 sind ohne weiteres auch auf Vertiefungen anwendbar, die nicht als Durchkontaktierungen ausgebildet sind. Beispielsweise sind Strukturen in einer Metallisierung der Leiterplatte oder Nuten in der Leiterplatte selbst als Vertiefungen möglich, die dann entsprechend geometrisch angeordnet sein können.

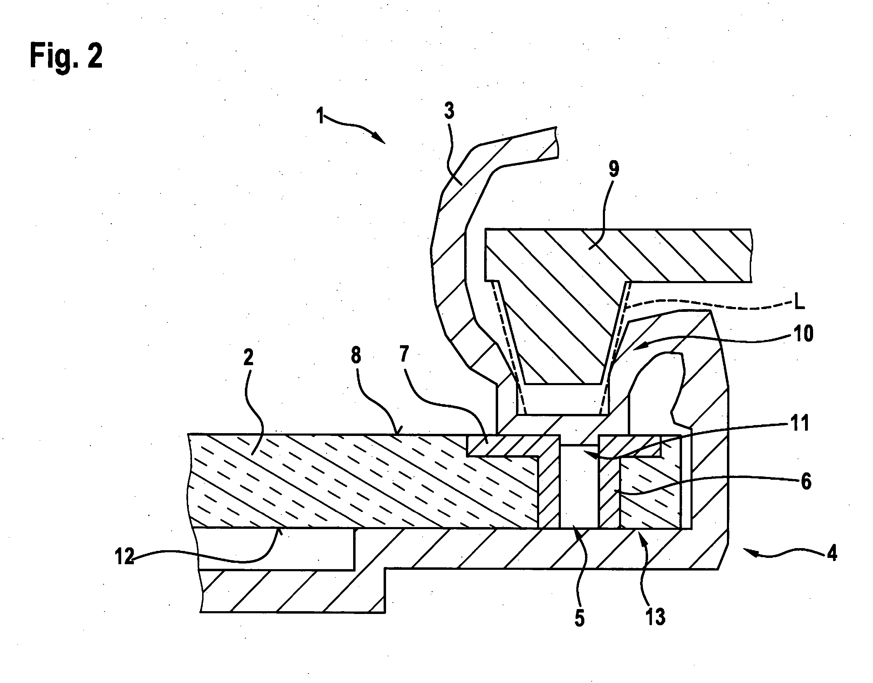

Figur 2 zeigt eine beidseitig abgebrochene, schematische Querschnittsdarstellung der elektrischen Schaltungsanordnung 1 und des Prägestempels 9 gemäß Figur 1 nach einer mechanischen Verformung des Verformungsbereichs 10. Mit einer gestrichelten Linie L ist der Prägestempel 9 in seinem Umkehrpunkt während der mechanischen Verformung des Verformungsbereiches 10 dargestellt. Es zeigt sich, dass der Verformungsbereich 10 durch den Prägestempel 9 derart mechanisch verformt wird, dass er in einem Bereich 11 in die Durchkontaktierung 5 eingeformt wird. Insbesondere wird er in die Durchkontaktierung 5 eingeprägt.

Bei dem dargestellten Ausführungsbeispiel ist das Gehäuse einstückig ausgebildet. Es weist vorzugsweise ein leitfähiges Material, ganz bevorzugt Metall auf. Besonders bevorzugt ist das Gehäuse 3 aus fließgepresstem Aluminium hergestellt. Wird in einem solchen Fall der Verformungsbereich 10 bereichsweise, nämlich in dem Bereich 11, in die Durchkontaktierung 5 eingeformt, entsteht hier ein ohmscher Kontakt zwischen dem Gehäuse 3 und der Leiterplatte 2. Konkret wird der Kontakt hier hergestellt zwischen dem Verformungsbereich 10 einerseits und der Metallisierung 6 sowie dem Pad 7. Der Kontakt ist gasdicht. Es wird außerdem durch Formschluss eine hohe Haltekraft und gute laterale Fixierung der Leiterplatte 2 relativ zu dem Gehäuse 3 sichergestellt. Auch hierdurch kann insbesondere ein niederohmiger Kontakt zwischen der Leiterplatte 2 und dem Gehäuse 3 über die Lebensdauer der elektrischen Schaltungsanordnung 1 gewährleistet werden.

Durch die mechanische Verformung des Verformungsbereichs 10 wird außerdem die Leiterplatte 2 mit ihrer der Oberfläche 8 abgewandten Oberfläche 12 gegen einen Auflagebereich 13 des Führungsbereichs 4 gedrängt. Dies bewirkt zum Einen eine mechanische Fixierung der Leiterplatte in dem Gehäuse 3, zum Anderen wird so auch ein guter thermischer Kontakt zwischen der Leiterplatte 2 und dem Gehäuse 3 sichergestellt. Wärme, die von elektrischen und/oder elektronischen Bauteilen erzeugt wird, welche auf der Leiterplatte vorgesehen sind, kann so über das Gehäuse 3 an die Umgebung abgegeben werden.

Die im Zusammenhang mit dem Ausführungsbeispiel genannten Vorteile und Effekte einer Durchkontaktierung 5 ergeben sich ohne weiteres auch für andere Ausführungsbeispiele von Vertiefungen, beispielsweise für Strukturen in einer Metallisierung der Leiterplatte, oder eine Nut, welche in der Leiterplatte selbst vorgesehen ist.

Die elektrische Schaltungsanordnung 1 wird bevorzugt als Steuergerät, insbesondere für Kraftfahrzeuge, besonders bevorzugt als EPS Motorsteuergerät beziehungsweise EPS Motorsteuergeräte-Plattform eingesetzt.

## Patentansprüche

1. Elektrische Schaltungsanordnung, insbesondere für ein Steuergerät eines Kraftfahrzeugs, mit mindestens einer Leiterplatte (2) und einem Gehäuse (3), wobei das Gehäuse (3) mindestens einen Führungsbereich (4) zur Führung der mindestens einen Leiterplatte (2) aufweist, **dadurch gekennzeichnet, dass** die mindestens eine Leiterplatte (2) mindestens eine Vertiefung aufweist, und dass das Gehäuse (3) in mindestens einem Verformungsbereich (10) des mindestens einen Führungsbereichs (4) derart mechanisch verformt ist, dass der mindestens eine Verformungsbereich (10) zumindest bereichsweise in die mindestens eine Vertiefung eingeformt ist, wobei die mindestens eine Leiterplatte (2) zumindest im Bereich der mindestens einen Vertiefung metallisiert ist.

2. Elektrische Schaltungsanordnung nach Anspruch 1, **dadurch gekennzeichnet, dass** die Vertiefung als Struktur, beispielsweise Nut, in einer Metallisierung der Leiterplatte (2) oder als Nut oder Durchkontaktierung in der Leiterplatte (2) ausgebildet ist.

3. Elektrische Schaltungsanordnung nach Anspruch 1, **dadurch gekennzeichnet, dass** die Metallisierung (6) Kupfer aufweist.

4. Elektrische Schaltungsanordnung nach einem der vorhergehenden Ansprüche, **dadurch gekennzeichnet, dass** mehr als eine Vertiefung an der mindestens einen Leiterplatte (2) vorgesehen ist, wobei vorzugsweise in mindestens einem geführten Bereich der Leiterplatte (2) mindestens eine Reihe von Vertiefungen in einer Einschubrichtung der Leiterplatte (2) in das Gehäuse (3) und/oder in einer Richtung senkrecht hierzu angeordnet ist.

5. Elektrische Schaltungsanordnung nach einem der vorhergehenden Ansprüche, **dadurch gekennzeichnet, dass** das Gehäuse (3) einstückig ist und bevorzugt aus fließgepresstem Aluminium hergestellt ist.

6. Elektrische Schaltungsanordnung nach einem der vorhergehenden Ansprüche, **dadurch gekennzeichnet, dass** das Gehäuse (3) als Einschubgehäuse ausgebildet ist.

7. Verfahren zur Herstellung einer elektrischen Schaltungsanordnung (1), insbesondere nach einem oder mehreren der vorhergehenden Ansprüche und insbesondere zur Fixierung mindestens einer Leiterplatte (2) in einem Gehäuse (3), wobei mindestens eine Leiterplatte (2) zumindest bereichsweise in mindestens einen Führungsbereich (4) eines Gehäuses (3) eingebracht wird, **dadurch gekennzeichnet, dass** an der mindestens einen Leiterplatte mindestens eine Vertiefung vorgesehen und die mindestens eine Leiterplatte (2) zumindest im Bereich der mindestens einen Vertiefung metallisiert wird, und dass das Gehäuse (3) in mindestens einem Verformungsbereich (10) des mindestens einen Führungsbereichs (4) derart mechanisch verformt wird, dass der Verformungsbereich (10) zumindest bereichsweise in die mindestens eine Vertiefung eingeformt wird.

8. Verfahren nach Anspruch 7, **dadurch gekennzeichnet, dass** der Verformungsbereich (10) zumindest bereichsweise in die mindestens eine Vertiefung eingeprägt wird.

9. Verfahren nach einem der Ansprüche 7 oder 8, **dadurch gekennzeichnet, dass** im Bereich der Einformung des mindestens einen Verformungsbereichs (10) in die mindestens eine Vertiefung ein ohmscher Kontakt zwischen der mindestens einen Leiterplatte (2) und dem Gehäuse (3) hergestellt wird.

## Claims

1. Electrical circuit arrangement, in particular for a controller of a motor vehicle, having at least one printed circuit board (2) and a housing (3), wherein the housing (3) has at least one guide region (4) for guiding the at least one printed circuit board (2), **characterized in that** the at least one printed circuit board (2) has at least one recess, and **in that** the housing (3) is mechanically deformed in at least one deformation region (10) of the at least one guide region (4) in such a way that the at least one deformation region (10) is moulded at least in regions into the at least one recess, wherein the at least one printed circuit board (2) is metallized at least in the region of the at least one recess.

2. Electrical circuit arrangement according to Claim 1, **characterized in that** the recess is in the form of a structure, for example a groove, in a metallization of the printed circuit board (2) or in the form of a groove or plated-through hole in the printed circuit board (2).

3. Electrical circuit arrangement according to Claim 1, **characterized in that** the metallization (6) comprises copper.

4. Electrical circuit arrangement according to one of the preceding claims, **characterized in that** more than one recess is provided in the at least one printed circuit board (2), wherein at least one row of recesses is arranged in a direction in which the printed circuit board (2) is inserted into the housing (3) and/or in a direction perpendicular to the said insertion direction, preferably in at least a guided region of the printed circuit board (2).

5. Electrical circuit arrangement according to one of the preceding claims, **characterized in that** the housing (3) is integral and is preferably produced from extruded aluminium.

6. Electrical circuit arrangement according to one of the preceding claims, **characterized in that** the housing (3) is in the form of a withdrawable housing.

7. Method for producing an electrical circuit arrangement (1), in particular according to one or more of the preceding claims and, in particular, for fixing at least one printed circuit board (2) in a housing (3), wherein at least one printed circuit board (2) is inserted at least in regions into at least one guide region (4) of a housing (3), **characterized in that** at least one recess is provided on the at least one printed circuit board, and the at least one printed circuit board (2) is metallized at least in the region of the at least one recess, and **in that** the housing (3) is mechanically deformed in at least one deformation region (10) of the at least one guide region (4) in such a way that the deformation region (10) is moulded at least in regions into the at least one recess.

8. Method according to Claim 7, **characterized in that** the deformation region (10) is impressed at least in regions into the at least one recess.

9. Method according to either of Claims 7 and 8, **characterized in that** a resistive contact is established between the at least one printed circuit board (2) and the housing (3) in the region of the moulding of the at least one deformation region (10) into the at least one recess.

## Revendications

1. Circuit électrique, en particulier pour un appareil de commande d'un véhicule automobile, comprenant au moins une carte à circuits imprimés (2) et un boîtier (3), le boîtier (3) présentant au moins une région de guidage (4) pour guider l'au moins une carte à circuits imprimés (2), **caractérisé en ce que** l'au moins une carte à circuits imprimés (2) présente au moins un renfoncement et **en ce que** le boîtier (3) est déformé mécaniquement dans au moins une région de déformation (10) de l'au moins une région de guidage (4) de telle sorte que l'au moins une région de déformation (10) soit formée au moins en partie dans l'au moins un renfoncement, l'au moins une carte à circuits imprimés (2) étant métallisée au moins dans la région de l'au moins un renfoncement.

2. Circuit électrique selon la revendication 1, **caractérisé en ce que** le renfoncement est réalisé sous forme de structure, par exemple de rainure, dans une métallisation de la carte à circuits imprimés (2) ou sous forme de rainure ou de contact traversant dans la carte à circuits imprimés (2).

3. Circuit électrique selon la revendication 1, **caractérisé en ce que** la métallisation (6) présente du cuivre.

4. Circuit électrique selon l'une quelconque des revendications précédentes, **caractérisé en ce que** plus d'un renfoncement est prévu au niveau de l'au moins une carte à circuits imprimés (2), au moins une rangée de renfoncements étant disposée de préférence dans au moins une région guidée de la carte à circuits imprimés (2) dans une direction d'insertion de la carte à circuits imprimés (2) dans le boîtier (3) et/ou dans une direction perpendiculaire à celle-ci.

5. Circuit électrique selon l'une quelconque des revendications précédentes, **caractérisé en ce que** le boîtier (3) est réalisé d'une seule pièce et est fabriqué de préférence en aluminium filé.

6. Circuit électrique selon l'une quelconque des revendications précédentes, **caractérisé en ce que** le boîtier (3) est réalisé sous forme de boîtier insérable.

7. Procédé de fabrication d'un circuit électrique (1), en particulier selon l'une quelconque ou plusieurs des revendications précédentes et notamment pour la fixation d'au moins une carte à circuits imprimés (2) dans un boîtier (3), au moins une carte à circuits imprimés (2) étant introduite au moins en partie dans au moins une région de guidage (4) d'un boîtier (3), **caractérisé en ce qu'**au niveau de l'au moins une carte à circuits imprimés est prévu au moins un renfoncement et l'au moins une carte à circuits imprimés (2) est métallisée au moins dans la région de l'au moins un renfoncement, et **en ce que** le boîtier (3), dans moins une région de déformation (10) de l'au moins une région de guidage (4), est déformé mécaniquement de telle sorte que la région de déformation (10) soit formée au moins en partie dans l'au moins un renfoncement.

8. Procédé selon la revendication 7, **caractérisé en ce que** la région de déformation (10) est inscrite au moins en partie dans l'au moins un renfoncement.

9. Procédé selon l'une quelconque des revendications 7 ou 8, **caractérisé en ce que**, dans la région de la formation de l'au moins une région de déformation (10) dans l'au moins un renfoncement, est réalisé un contact ohmique entre l'au moins une carte à circuits imprimés (2) et le boîtier (3) .
